# EUROPEAN PATENT SPECIFICATION

(11) **EP 1 079 207 B1**
(45) Date of publication and mention of the grant of the patent: **23.05.2007**
(21) Application number: 00307340.0
(22) Date of filing: 25.08.2000
(51) Int. Cl.: G01D 5/25, G01D 4/00, G01R 11/24, G01F 15/06, G01F 15/00

(54) **Magnetic rotary sensor**
Magnetischer Drehgeber
Capteur de rotation magnétique

(30) Priority: 27.08.1999 GB 9920241
(43) Date of publication of application: 28.02.2001
(73) Proprietor: KEY SAFETY SYSTEMS, INC., Sterling Heights, MI 48314 (US)
(72) Inventor: Edwards, Paul K., Old Catton, Norwich Norfolk NR6 6DR (GB)
(74) Representative: Croston, David

(56) References cited:
- DE-A- 3 930 798
- DE-A- 19 725 247
- FR-A- 2 655 155

## Description

The present invention relates to meters which convert mechanical rotation into an electronic signal.

A large variety of meters are designed to measure a flow of fluid, such as water or gas, or measure a flow of electricity over time. Typically the flow is used to generate mechanical rotation which operates through a gear train to produce a dial indication of total quantity. Examples are odometers, water meters, gas meters, electrical meters, hour meters, etc. These devices were largely developed before the advent of modern digital circuitry. Today many meters are read remotely, or by a digital computer or microprocessor. Thus an hour meter on a piece of equipment may need to send a digital signal to a microprocessor which controls and monitors that equipment. Water meters for example can be read remotely, for example outside a building or home, to facilitate manual reading. A remote reading may also be accomplished over the phone or by radio or satellite linked to a central computer.

The ubiquitous nature of metering devices means cost, together with high reliability, is a prime consideration. A highly reliable mechanical switch generally means a reed switch, with its hermetically sealed contacts and life of up to one billion cycles without failure, depending on the current applied to the circuit. Meter mechanisms have been modified to produce an electrical output by mounting a magnet on the mechanical output dial and detecting rotation of the magnet with a reed switch. Unfortunately, tampering with the meter is always a concern where the meter output is used to calculate a charge to a consumer.

In the prior art, a gas meter, resp. a water meter, which has a tampering-detection ability is known from FR 2 655 155, resp. DE 197 25 247.

What is needed is a way to convert a rotating dial output to a digital electrical signal which is of greater resolution and which can detect tampering.

According to a first aspect of the invention there is provided an apparatus for converting a rotary motion into digital signals comprising:
a housing;
a platter mounted for rotation about an axis to the housing, the platter having a magnet receiving surface and a gear engaging means mounted thereto;
a magnet mounted to the magnet receiving surface of the platter defining a magnet plane, the magnet having a multiplicity of poles arranged sequentially equally radially spaced about the axis of rotation, the rotation of the magnet defining a circular path along which the magnetic poles are sequentially arrayed;
a substantially planar circuit board mounted to the housing;
a first reed switch having a first reed switch axis, the first reed switch being mounted to the circuit board and positioned so the first reed switch axis closely spaced from the magnet and parallel to a tangent of the circular path defined by the magnet so that rotation of the magnet with the platter causes the first reed switch to open and close once for each of said multiplicity of poles for each complete rotation of the magnet;
a second reed switch mounted to the circuit board and closely spaced to the second reed switch but sufficiently spaced from the magnet so that rotation of the magnet does not cause the second reed switch to close, the second reed switch for detecting extraneous magnetic fields so as to detect tampering; characterised in that the plane of the circuit board is parallel with the axis of rotation of the platter, and in that the first reed switch is arranged in the plane of the magnet and the second reed switch is arranged out of the plane of the magnet.

Furthermore, according to another aspect of the invention there is provided an apparatus as in claim 2.

In one embodiment a metering device of this invention employs a magnet with ten poles which is driven to rotate by a gear connected to a gear train which is connected to a source of rotation which is proportional to fluid flow, the passage of time, or other phenomena. A reed switch is mounted so that rotation of the poles of the magnet, into and out of a position adjacent to the reed switch, causes the reed switch to open and close as the magnet rotates. The opening and closing of the reed switch results in a step change in voltage applied to an electronic device which increments a counter. The result is a device which utilizes a reed switch to convert rotary motion into an electronic signal which can be easily transmitted to and processed by a computer.

Many metering devices are used to charge customers for the amount of some commodity consumed such as water, gas or electricity and so can provide a motivation for tampering. A second reed switch sufficiently spaced from the rotating magnet so that it remains normally closed can act as a sensitive device for detecting the presence of extraneous magnetic fields. Such extraneous magnetic fields can interfere with the operation of the first reed switch which acts to sense rotation of the multi-pole magnet.

The metering device may be designed for rapid human or robotic assembly. The components which make up the system for converting rotation into an electric signal consists of: a circuit board on which the rotation sensing reed switch and tamper sensing reed switch are mounted, together with resistors which are connected in series with the reed switches to limit the current flow through the circuit formed when the reed switch closes; a magnet carrier having a platter and a post extending from the platter; a ten-pole magnetic disk which is positioned on the platter like a record on a record player. A gear train is connected between a flow sensor and the platter which carries the multi-pole magnet.

The magnetic disk is retained by opposed resilient plastic fingers which extend upwardly from the platter through opposed slots and overlie the magnet. The magnet carrier can be a simple injection moulded part. The circuit board may be manufactured in accordance with the highly automated processes which have been developed for printed circuit board manufacture. The individual parts are readily assembled by simple placement on a suitable housing which incorporates the drive gear train and an upper face through which the dial rotates to drive a dial indicator.

It is a feature of the present invention to provide a means for converting rotary motion into a digital signal.

It is a further feature of the present invention to provide a mechanism for utilizing a reed switch to detect rotary motion.

It is a still further feature of the present invention to provide a meter for measurement of fluid flow over time which can detect tampering.

It is another feature of the present invention to provide a meter for measurement of fluid flow with greater resolution. The platter comprises frictional means which reduce gear backlash and hence vibration.

Further objects, features and advantages of the invention will be apparent from the following detailed description when taken in conjunction with the accompanying drawings, in which:
FIG. 1 is an isometric view of the components of this invention used to convert rotary motion to an electronic signal mounted on an application - specific meter housing.
FIG. 1 (a) is a view similar to fig.1 with the fascia and magnet arrangement removed showing the PCB,
FIG. 2 is a top plan view of the circuit board and rotary magnet of the device of FIG.1,
FIG.3 shows an alternative arrangement of the circuit board and rotary magnet,
FIG. 4 shows an alternative second reed switch to the second reed switch of figs. 1 and 2,
FIGS. 5-7 shows various ways of mounting an auxiliary magnet to the second reed switch, in particular:
FIG. 5 shows an auxiliary magnet insert moulded into a sleeve surrounding the second reed switch,

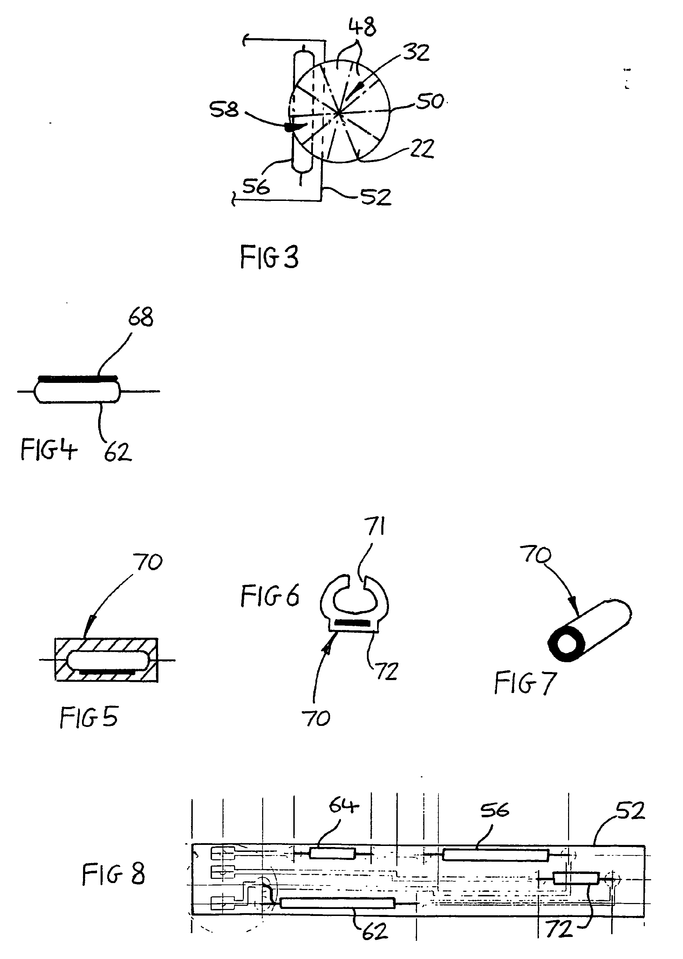

FIG. 6 shows an auxiliary magnet in a sleeve in the form of a clip,
FIG. 7 shows a tube-like sleeve magnetised so as to become an auxiliary magnet, and

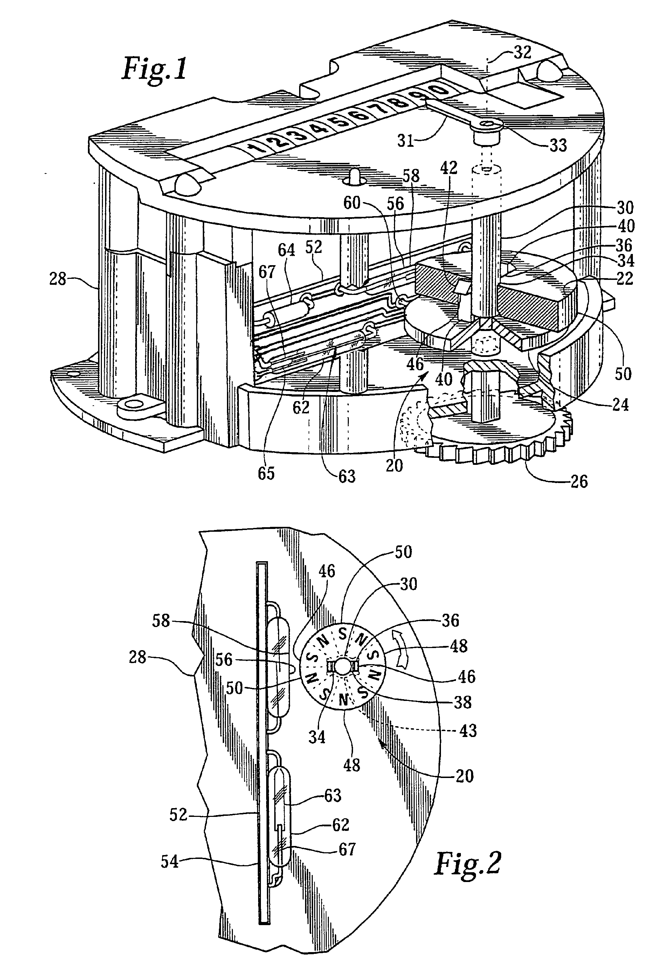

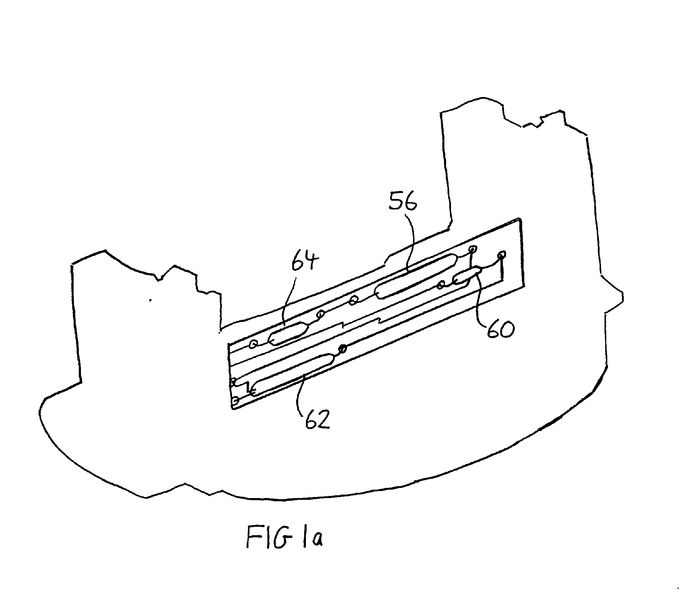

FIG. 8 shows an alternative circuit board layout to that in figures 1 and 2.

Referring more particularly to FIGS. 1-2, wherein like numbers refer to similar parts, an apparatus 20 for converting rotary motion to an electronic signal is shown. The components consist of a disk shaped magnet 22 which is mounted on a platter 24. The magnet is an isotropic ferrite (sintered). The platter 24 is part of an assembly which is keyed to a gear 26 which is driven by a gear train (not shown). The platter 24 is mounted for rotation about an axis 32 to a housing 28. A post 30 extends upwardly from the platter 24 along the axis of rotation 32. Such information may be useful in situations where a commodity like water is being measured, where flow rate information may have independent utility apart from metering quantity used.

It is desirable to mount the magnet 22 on the slowest moving portion of the gear train to minimize any effects of the inertia of the magnet. Further it is desirable to preserve as much of the characteristics of the existing mechanical meter as possible to preserve design experience and minimize cost.

As shown in FIG. 2, the magnet 22 has a central hole 34 and two rectangular openings 36 which extend from the hole 34 to form a single slotted hole 38. Two resilient fingers 40 extend upwardly of the platter 24. The resilient fingers 40 have inclined surfaces 42 which slope away from the axis of rotation 32. The inclined surfaces 42 cooperate with portions of the magnet 22 which form the rectangular openings 36 to bend the fingers 40 toward the central post 30, thereby allowing the magnet 22 to pass over the fingers 40. The fingers 40 have barbs 46 which fix the magnet 22 against rotation and translation with respect to the platter 24. The rectangular openings 36 may be provided with underside chamfers 43 to further aid in pressing the magnet down over the barbs 46 of the fingers 40.

The gear 26 is engaged by a gear train (not shown) which supplies rotary motion from a device such as an impeller which is caused to rotate by a flow of water, as in a water meter. The magnet 22 has ten magnetic poles 48 arranged around the periphery 50 of the magnetic disk 22. Rotation of the platter 24 causes the magnet to rotate about the axis of rotation 32.

A circuit board 52 is mounted to the housing 28 by portions 54 of the housing 28 which form a slot which fixedly positions the circuit board 52 with respect to the magnet 22 and platter 24. The circuit board comprises a first reed switch 56 which is positioned so the axis of the reed switch 56 is substantially tangential to and in the plane of the rotatable magnetic disk 22. The first reed switch 56 is of known form A Type (that is to say, a one pole arrangement). Thus, rotation of the disk sequentially brings each magnetic pole 48 into a position adjacent the central activation region 58 of the reed switch 56. The glass capsule of the reed switch 56 is spaced from the magnet 22.

In FIG.3 another embodiment of the invention is shown. All parts in FIG.3 correspond with parts in FIGS.1 and 2 and carry the same reference numerals. However, the orientation of the first reed switch 56 relative to the magnet 22 is different. The first reed switch 56 is now arranged beneath the magnet 22 looking axially of the magnet.

The reed switch 56 is arranged in line with a point of the magnet adjacent to the periphery 50 as shown in fig. 3. Conveniently, the circuit board 52 is turned approximately 90°. However, the orientation of the circuit board 52, and hence the first reed switch 56 in relation to the magnet is different. The first reed switch now lies so as to coincide with the periphery 50 of the magnet 22 as the periphery is extrapolated in the direction of a axis of rotation 32. Conveniently, the circuit board 52 is turned to approximately 90° with respect to its configuration of FIG. 1 and the circuit board 52 provides support to the reed switch 56.

When the magnet 22 is in the configuration described immediately above it is necessary for the magnetism characteristics of the magnet 22 to be different to those of the magnet of FIGS. 1 and 2, i.e. the magnet 22 is axially magnetised as opposed to the radially magnetised 22 of FIGS. 1 and 2. In that arrangement, in use, magnetism flows from the magnet 22 into the page in FIG. 3 towards the first reed switch 56.

Instead of a reed switch 56, a Hall effect type or giant magnet resistive (GMR) type sensor may be used.

Each pole of a magnet 22 induces an opposite pole in the reed switch providing the magnetic couple which causes the reed switch 56 to close. Between poles 48, the reed switch 56 opens, so the magnet 22 with ten poles results in ten openings, and ten closings of the reed switch. The reed switch 56 is configured and positioned so that for a constantly rotating magnet the reed switch is closed for part of the time and open for part of the time. The ratio between closed/open cycles facilitates the operation of the circuitry monitoring the rotation of the magnet 22. The ratio can be varied depending on the strength of the magnet and sensitivity of the reed switch.

A first resistor 60 which is connected in series with the first reed switch 56 is also mounted to the circuit board 52. The resistor 60 serves to limit the current flow through the first reed switch 56 and match the current flow to the counting circuitry (not shown). If reed switch current is limited, failure free performance of over one-hundred-million cycles is possible.

A second reed switch 62 of the so-called FORM C configuration is mounted to the circuit board 52 spaced from the magnet 22 so that it is not actuated by the rotation of the magnet 22. A FORM C reed switch has one movable reed 63 and two stationary reed contacts 65, 67. All three reeds are ferromagnetic, however the contact area of the first fixed reed 65, against which the movable reed 63 is biased, is formed of a non-magnetic metal which has been welded to the ferromagnetic lead 65. When exposed to a magnetic field, both fixed reeds 65, 67 assume the same polarity, which is opposite that of the movable reed 63, due to the non-magnetic metal, which forms a flux interrupter, the only attractive force of sufficient magnitude is between the moveable reed 63 and the contact on normally open reed 67 so the moveable reed 63, transfers from the contact on the normally closed reed 65 to the contact on the normally open reed 67.

The FORM C reed switch 62 provides a positive indication of being present through the normally closed contact 65 and provides a means of detecting an extraneous magnetic field through the normally open contact 67. Extraneous magnetic fields such as those caused by a magnet intentionally or accidentally positioned to interfere with the operation of the first reed switch 56 will cause a switch from the normally closed contact to the normally open contact. Because meters employing an apparatus 20 often are used to generate a usage charge based on the amount of a commodity metered, an indicator of tampering is critical.

A second resistor 64 is mounted in series with the normally closed reed 67 of the second reed switch 62 to again limit current flow to the circuitry detecting tampering (not shown). The second reed switch 62 is connected to a common ground and connects the circuitry detecting tampering through the second resistor 64 to the common ground (not shown). The first reed switch 56 is connected between the rotation detecting circuit (not shown) and the common ground so that when the first reed switch closes it connects the sensor rotation detecting circuit (not shown) to ground through the first resistor 60.

In FIG. 4 a further second reed switch 67 of a different kind is shown. Whereas the second reed switch 62 of FIGS. 1 and 2 uses a two-pole (commonly called a form C) arrangement, in FIG. 4 the second reed switch 62 has a one-pole (commonly called a Form A) arrangement. This second reed switch 62 has an auxiliary magnet 68 fitted thereto. This is know an "biasing" the second reed switch 62 i.e. causing it to be in a closed condition. The auxiliary magnet 68 may be glued to the second reed switch 62. It will appreciated that the auxiliary magnet 68 need only be small relative to the magnet 22.

In another development which overcomes the problem of gluing the auxiliary magnet 68 to the 11cm of reed switch 62 which is messy, permanent, time consuming and hence costly, the auxiliary magnet 68 is mounted on, or indeed takes the form of, a sleeve 70 as shown in FIGS. 5, 6 and 7.

The sleeve 70 may be made of plastics material.

More specifically, referring to FIG. 5 the auxiliary magnet 68 is insert moulded into the sleeve 70. The sleeve 70 takes the form of casing and surrounds the second reed switch 62. The auxiliary magnet 68 must be magnetised after the insert moulding process.

Referring to FIG. 6, the sleeve 70 is in the form of a resilient clip. It is tubular and has an opening along its length to allow it to be push-mounted onto the second reed switch 62. The sleeve 70 has an enlarged section 72, the auxiliary magnet 68 is located within the enlarged section 72. The opening 71 along the length of the sleeve 70 allows swift removal of the sleeve 70 from the second reed switch 62.

Referring to FIG. 7, the sleeve 70 is tube-like. The sleeve 70 is magnetised to become the auxiliary magnet 68. It is then slidably located on the second reed switch 62.

The immediately preceding disclosure only highlights a few ways in which the auxiliary magnet 68 could be mounted on the second reed switch 62. Obviously other types of sleeve 70 and indeed means other than the sleeve could be utilised.

FIG.8 shows a circuit board 52 having an altered track layout. The layout houses the second reed switch 62. The components 56, 62, 64 and 72 have a different configuration to that of FIG.1.

It should be understood that the housing arrangement and structure will depend on the particular meter into which the apparatus is incorporated. It should also be understood that the electronics which communicate with the circuit board may do so through wires soldered to the board or through a connector, interfaced directly with the board. Further wires soldered to the board may be led to connectors up mounted to the housing. Such housing connectors can then be connected to wires leading to a computer input circuitry or communication circuitry.

The gear train will determine the relationship between the measured flow and the rate of rotation of the disk. It will typically be chosen so the disk rotates at a rate which allows detection of minimum flow, and easy assessment of rate during maximum flow. For a typical water meter one rotation of an indicating dial will correspond to one gallon of water metered. The platter comprises frictional damping means which reduces gear backlash and hence vibration.

It should be understood that a gear may be incorporated into and integral with the platter and be driven by a gear forming part of a gear train.

It should be understood that the invention is not limited to the particular construction and arrangement of parts herein illustrated and described, but embraces such modified forms thereof as come within the scope of the following claims.

## Claims

1. An apparatus for converting a rotary motion into digital signals comprising:
a housing (28);
a platter (24) mounted for rotation about an axis to the housing, the platter having a magnet receiving surface and a gear engaging means mounted thereto;
a magnet (22) mounted to the magnet receiving surface of the platter defining a magnet plane, the magnet having a multiplicity of poles arranged sequentially equally radially spaced about the axis of rotation, the rotation of the magnet defining a circular path along which the magnetic poles are sequentially arrayed;
a substantially planar circuit board (52) mounted to the housing;
a first reed switch (56) having a first reed switch axis, the first reed switch being mounted to the circuit board and positioned so the first reed switch axis is closely spaced from the magnet and parallel to a tangent of the circular path defined by the magnet so that rotation of the magnet with the platter causes the first reed switch to open and close once for each of said multiplicity of poles for each complete rotation of the magnet;
a second reed switch (62) mounted to the circuit board and closely spaced to the first reed switch but sufficiently spaced from the magnet so that rotation of the magnet does not cause the second reed switch to open, the second reed switch for detecting extraneous magnetic fields so as to detect tampering;
**characterised in that** the plane of the circuit board is parallel with the axis of rotation of the platter, and **in that** the first reed switch is arranged in the plane of the magnet and the second reed switch is arranged out of the plane of the magnet.

2. An apparatus for converting a rotary motion into digital signals comprising:
a housing (28);
a platter (24) mounted for rotation about an axis to the housing, the platter having a magnet receiving surface and a gear engaging means mounted thereto;
a magnet (22) mounted to the magnet receiving surface of the platter defining a magnet plane, the magnet having a multiplicity of poles arranged sequentially equally radially spaced about the axis of rotation, the rotation of the magnet defining a circular path along which the magnetic poles are sequentially arrayed;
a substantially planar circuit board (52) mounted to the housing;
a first reed switch (56) having a first reed switch axis, the first reed switch being mounted to the circuit board and positioned so the first reed switch axis is closely spaced from the magnet and parallel to a tangent of the circular path defined by the magnet so that rotation of the magnet with the platter causes the first reed switch to open and close once for each of said multiplicity of poles for each complete rotation of the magnet;
a second reed switch (62) mounted to the circuit board and closely spaced to the first reed switch but sufficiently spaced from the magnet so that rotation of the magnet does not cause the second reed switch to open, the second reed switch for detecting extraneous magnetic fields so as to detect tampering;
**characterised in that** the plane of the circuit board is parallel with the magnet plane, and **in that** the first reed switch is arranged axially in line with the magnet and the second reed switch is arranged axially out of line with the magnet.

3. The apparatus of Claim 1 or 2 wherein the first reed switch is of a single pole type.

4. The apparatus of Claim 1 or 2 wherein the second reed switch is of a single pole type.

5. The apparatus of Claim 1 or 2 wherein the second reed switch is of the type having a single moveable reed and two stationary contacts, and wherein the moveable reed is biased against a first contact when an extraneous magnetic field is not present.

6. The apparatus of any preceding claim wherein the magnet has ten poles.

7. The apparatus of any preceding claim wherein the magnet is held positioned to the rotating platter by resilient fingers which engage the magnet when it is pressed into engagement with the magnet receiving surface.

8. The apparatus of any preceding claim wherein the platter has a post extending along the axis of the platter, and a dial indicator attached to the post for making visually apparent the rotation of the platter.

## Patentansprüche

1. Vorrichtung zum Umwandeln einer Drehbewegung in digitale Signale, wobei die Vorrichtung Folgendes umfasst:
ein Gehäuse (28),
eine für eine Drehung um eine Achse am Gehäuse angebrachte Grundplatine (24), wobei die Grundplatine eine Magnetaufnahmefläche und ein daran angebrachtes Getriebe-Eingriffsmittel hat,
einen an der Magnetaufnahmefläche der Grundplatine angebrachten Magneten (22), der eine Magnetebene definiert, wobei der Magnet eine Vielzahl von aufeinanderfolgend mit gleichem Radialabstand um die Rotationsachse angeordneten Polen hat, wobei die Drehung des Magneten eine kreisförmige Bahn definiert, längs derer die Magnetpole aufeinanderfolgend angeordnet sind,
eine am Gehäuse angebrachte, in Wesentlichen ebene Leiterplatte (52),
einen ersten Zungenschalter (56), der eine erste Zungenschalterachse hat, wobei der erste Zungenschalter an der Leiterplatte angebracht und so angeordnet ist, dass die erste Zungenschalterachse mit engem Abstand zum Magneten und parallel zur Tangente der durch den Magneten definierten kreisförmigen Bahn angeordnet ist, so dass ein Drehen des Magneten mit der Grundplatine bewirkt, dass der erste Zungenschalter für jeden der Vielzahl von Polen für jede vollständige Umdrehung des Magneten einmal öffnet und schließt,
einen zweiten an der Leiterplatte angebrachten und mit engem Abstand zum ersten Zungenschalter angeordneten zweiten Zungenschalter (62), der aber mit ausreichendem Abstand zum Magneten angeordnet ist, so dass ein Drehen des Magneten nicht bewirkt, dass der zweite Zungenschalter öffnet, wobei der zweite Zungenschalter zum Erkennen äußerer Magnetfelder dient, um so einen unbefugten Eingriff zu erkennen,
**dadurch gekennzeichnet, dass** die Ebene der Leiterplatte parallel zur Rotationsachse der Platine ist, und dadurch, dass der erste Zungenschalter in der Ebene des Magneten angeordnet ist und der zweite Zungenschalter außerhalb der Ebene des Magneten angeordnet ist.

2. Vorrichtung zum Umwandeln einer Drehbewegung in digitale Signale, die Folgendes umfasst:
ein Gehäuse (28),
eine für eine Drehung um eine Achse am Gehäuse angebrachte Grundplatine (24), wobei die Grundplatine eine Magnetaufnahmefläche und ein daran angebrachtes Getriebe-Eingriffsmittel hat,
einen an der Magnetaufnahmefläche der Grundplatine angebrachten Magneten (22), der eine Magnetebene definiert, wobei der Magnet eine Vielzahl von aufeinanderfolgend mit gleichem Radialabstand um die Rotationsachse angeordneten Polen hat, wobei die Drehung des Magneten eine kreisförmige Bahn definiert, längs derer die Magnetpole aufeinanderfolgend angeordnet sind,
eine am Gehäuse angebrachte, in Wesentlichen ebene Leiterplatte (52),
einen ersten Zungenschalter (56), der eine erste Zungenschalterachse hat, wobei der erste Zungenschalter an der Leiterplatte angebracht und so angeordnet ist, dass die erste Zungenschalterachse mit engem Abstand zum Magneten und parallel zur Tangente der durch den Magneten definierten kreisförmigen Bahn angeordnet ist, so dass ein Drehen des Magneten mit der Grundplatine bewirkt, dass der erste Zungenschalter für jeden der Vielzahl von Polen für jede vollständige Umdrehung des Magneten einmal öffnet und schließt,
einen zweiten an der Leiterplatte angebrachten und mit engem Abstand zum ersten Zungenschalter angeordneten zweiten Zungenschalter (62), der aber mit ausreichendem Abstand zum Magneten angeordnet ist, so dass ein Drehen des Magneten nicht bewirkt, dass der zweite Zungenschalter öffnet, wobei der zweite Zungenschalter zum Erkennen äußerer Magnetfelder dient, um so einen unbefugten Eingriff zu erkennen,
**dadurch gekennzeichnet, dass** die Ebene der Leiterplatte parallel zur Magnetebene ist, und dadurch, dass der erste Zungenschalter in Axialrichtung in einer Linie mit dem Magneten angeordnet ist und der zweite Zungenschalter in Axialrichtung außerhalb einer Linie mit dem Magneten angeordnet ist.

3. Vorrichtung nach Anspruch 1 oder 2, wobei der erste Zungenschalter von einem einpoligen Typ ist.

4. Vorrichtung nach Anspruch 1 oder 2, wobei der zweite Zungenschalter von einem einpoligen Typ ist.

5. Vorrichtung nach Anspruch 1 oder 2, wobei der zweite Zungenschalter von dem Typ ist, der eine einzelne bewegliche Zunge und zwei unbewegliche Kontakte hat, und wobei die bewegliche Zunge gegen einen ersten Kontakt vorgespannt wird, wenn kein äußeres Magnetfeld vorhanden ist.

6. Vorrichtung nach einem der vorhergehenden Ansprüche, wobei der Magnet zehn Pole hat.

7. Vorrichtung nach einem der vorhergehenden Ansprüche, wobei der Magnet durch elastische Finger, die den Magneten in Eingriff nehmen, wenn er in Eingriff mit der Magnetaufnahmefläche gedrückt wird, an der sich drehenden Grundplatine angeordnet gehalten wird.

8. Vorrichtung nach einem der vorhergehenden Ansprüche, wobei die Grundplatine einen Pfosten, der sich längs der Achse der Grundplatine erstreckt, und einen an dem Pfosten befestigten Feinzeiger hat, um das Drehen der Grundplatte optisch sichtbar zu machen.

## Revendications

1. Dispositif pour convertir un mouvement de rotation en signaux numériques, comprenant:
un boîtier (28);
un plateau (24) monté de manière à pouvoir effectuer une rotation autour d'un axe du boîtier, le plateau possédant une surface de réception d'aimant et un moyen d'engagement d'engrenage monté sur le plateau;
un aimant (22) monté sur la surface de réception d'aimant du plateau définissant un plan d'aimant, l'aimant étant pourvu d'une multiplicité de pôles disposés radialement de manière séquentielle et équidistante autour de l'axe de rotation, la rotation de l'aimant définissant une trajectoire circulaire le long de laquelle les pôles magnétiques sont disposés de manière séquentielle;
une carte de circuit imprimé (52) essentiellement plane montée sur le boîtier; un premier interrupteur à lames souples (56) pourvu d'un axe de premier interrupteur à lames souples, le premier interrupteur à lames souples étant monté sur la carte de circuit imprimé et positionné de manière à ce que l'axe de premier interrupteur à lames souples soit situé à une proche distance de l'aimant et parallèle à une tangente de la trajectoire circulaire définie par l'aimant de manière à ce que la rotation de l'aimant avec le plateau amène le premier interrupteur à lames souples à s'ouvrir et se fermer une fois pour chaque pôle de ladite multiplicité de pôles pour chaque rotation complète de l'aimant;
un second interrupteur à lames souples (62) monté sur la carte de circuit imprimé et situé à une proche distance du premier interrupteur à lames souples, mais à une distance suffisante de l'aimant, de manière à ce que la rotation de l'aimant ne provoque pas l'ouverture du second interrupteur à lames souples, le second interrupteur à lames souples servant à détecter des champs magnétiques étrangers de manière à détecter des manipulations;
**caractérisé par le fait que** le plan de la carte de circuit imprimé est parallèle à l'axe de rotation du plateau et **par le fait que** le premier interrupteur à lames souples est situé dans le plan de l'aimant et le second interrupteur à lames souples est situé en dehors du plan de l'aimant.

2. Dispositif pour convertir un mouvement de rotation en signaux numériques, comprenant:
un boîtier (28);
un plateau (24) monté de manière à pouvoir effectuer une rotation autour d'un axe du boîtier, le plateau possédant une surface de réception d'aimant et un moyen d'engagement d'engrenage monté sur le plateau;
un aimant (22) monté sur la surface de réception d'aimant du plateau définissant un plan d'aimant, l'aimant étant pourvu d'une multiplicité de pôles disposés radialement de manière séquentielle et équidistante autour de l'axe de rotation, la rotation de l'aimant définissant une trajectoire circulaire le long de laquelle les pôles magnétiques sont disposés de manière séquentielle;
une carte de circuit imprimé (52) essentiellement plane montée sur le boîtier;
un premier interrupteur à lames souples (56) pourvu d'un axe de premier interrupteur à lames souples, le premier interrupteur à lames souples étant monté sur la carte de circuit imprimé et positionné de manière à ce que l'axe de premier interrupteur à lames souples soit situé à une proche distance de l'aimant et parallèle à une tangente de la trajectoire circulaire définie par l'aimant de manière à ce que la rotation de l'aimant avec le plateau amène le premier interrupteur à lames souples à s'ouvrir et se fermer une fois pour chaque pôle de ladite multiplicité de pôles pour chaque rotation complète de l'aimant;
un second interrupteur à lames souples (62) monté sur la carte de circuit imprimé et situé à une proche distance du premier interrupteur à lames souples, mais à une distance suffisante de l'aimant, de manière à ce que la rotation de l'aimant ne provoque pas l'ouverture du second interrupteur à lames souples, le second interrupteur à lames souples servant à détecter des champs magnétiques étrangers de manière à détecter des manipulations;
**caractérisé par le fait que** le plan de la carte de circuit imprimé est parallèle au plan d'aimant et **par le fait que** le premier interrupteur à lames souples est aligné axialement avec l'aimant et le second interrupteur à lames souples n'est pas aligné axialement avec l'aimant.

3. Dispositif selon la revendication 1 ou 2, dans lequel le premier interrupteur à lames souples est d'un type à pôle unique.

4. Dispositif selon la revendication 1 ou 2, dans lequel le second interrupteur à lames souples est d'un type à pôle unique.

5. Dispositif selon la revendication 1 ou 2, dans lequel le second interrupteur à lames souples est du type possédant une seule lame souple mobile et deux contacts fixes et dans lequel la lame souple mobile est contrainte contre un premier contact lorsqu'il n'existe pas de champ magnétique étranger.

6. Dispositif selon l'une quelconque des revendications précédentes, dans lequel l'aimant possède dix pôles.

7. Dispositif selon l'une quelconque des revendications précédentes, dans lequel l'aimant est maintenu en position sur le plateau rotatif par des doigts élastiques qui se mettent en prise avec l'aimant lorsque celui-ci est pressé et mis en contact avec la surface de réception d'aimant.

8. Dispositif selon l'une quelconque des revendications précédentes, dans lequel le plateau possède une colonne s'étendant le long de l'axe du plateau et un indicateur à cadran fixé sur la colonne pour rendre apparente sur un plan visuel la rotation du plateau.
